Europäisches Patentamt

European Patent Office

Office européen des brevets

(11) Veröffentlichungsnummer: **0 396 812**
**A1**

(12) **EUROPÄISCHE PATENTANMELDUNG**

(21) Anmeldenummer: **89108610.0**

(22) Anmeldetag: **12.05.89**

(51) Int. Cl.5: **H03K 17/30, H03K 17/22**

(43) Veröffentlichungstag der Anmeldung:
**14.11.90 Patentblatt 90/46**

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**D-8000 München 2(DE)**

(72) Erfinder: **Murphy, Brian**
**Balmungstrasse 7**
**D-8000 München 19(DE)**

(54) **Schwellwertschalter.**

(57) Der erfindungsgemäße Schwellwertschalter dient dem Erkennen eines Minimalwertes VCCmin eines elektrischen Potentials. Er enthält zwei Referenzspannungsquellen UREF1, UREF2 und einen Differenzverstärker DIFF. Die erste Referenzspannungsquelle UREF1 ist vorzugsweise eine Spannungsteilerschaltung. Die zweite Referenzspannungsquelle UREF2 enthält vorzugsweise eine Kettenschaltung von Dioden D und in Serie dazu einen Transistor T. Der erfindungsgemäße Schwellwertschalter weist sehr geringe Herstellungstoleranzen bezüglich des zu erkennenden Minimalwertes VCCmin auf.

# FIG 1

## Schwellwertschalter

Die Erfindung betrifft einen Schwellwertschalter zum Erkennen eines Minimalwertes eines elektrischen Potentials.

Beim Anschalten von Versorgungsspannungen beispielsweise an integrierte Halbleiterschaltkreise ist es meist unerwünscht, daß während der sogenannten "Power-on"-Phase, innerhalb der die Versorgungsspannung noch nicht mindestens einen Wert erreicht hat, der als Minimalwert für den Betrieb zugelassen ist, die einzelnen Schaltelemente des Halbleiterschaltkreises bereits ihren Betrieb aufnehmen. Dabei können unerwünschte Nebeneffekte auftreten, die unter ungünstigen Umständen den Schaltkreis sogar irreparabel beschädigen könnten oder die Ausgangssignale des Halbleiterschaltkreises erzeugen könnten, die andere, mit dem Halbleiterschaltkreis verbundene elektrische oder elektronische Einrichtungen beschädigen könnten. Beispielsweise könnte bei einem in CMOS-Technologie integrierten Halbleiterschaltkreis der gefürchtete, den Schaltkreis unter Umständen zerstörende Latch-up-Effekt auftreten.

Aufgabe der vorliegenden Erfindung ist es, eine Anordnung zu schaffen, die das Erreichen eines Minimalwertes eines elektrischen Potentials erkennt und entsprechend ein Freigabesignal abgibt, um so eine andere Schaltungsanordnung zu schützen.

Diese Aufgabe wird gelöst durch einen Schwellwertschalter mit den Merkmalen des Patentanspruches 1. Vorteilhafte Aus- und Weiterbildungen sind in Unteransprüchen gekennzeichnet.

Die Erfindung wird anhand von Figuren näher erläutert. Es zeigen:

FIG 1 eine Darstellung der Erfindung,
FIG 2 zugehörige Potentialverläufe.

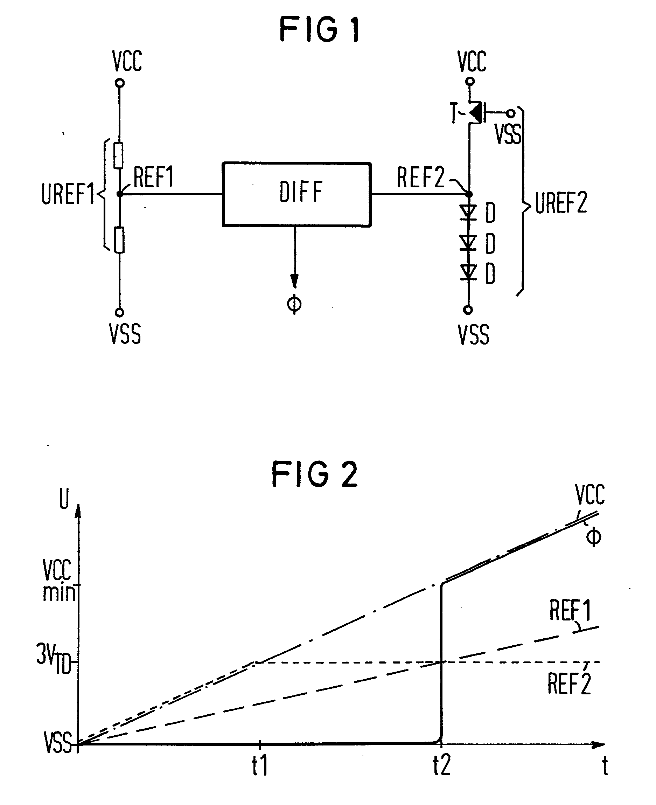

Der erfindungsgemäße Schwellwertschalter enthält gemäß FIG 1 eine erste Referenzspannungsquelle UREF1 und eine zweite Referenzspannungsquelle UREF2. Beide Referenzspannungsquellen UREF1,UREF2 sind mit einem ersten Versorgungspotential VSS und mit einem zweiten Versorgungspotential VCC verbunden. Das erste Versorgungspotential VSS ist dabei ein Potential, das meist als Bezugspotential der zu schützenden Schaltungsanordnung dient. Es wird häufig mit "Masse" bezeichnet. Das zweite Versorgungspotential VCC ist dasjenige Potential, das daraufhin überwacht werden soll, ob es einen festgelegten Minimalwert VCCmin erreicht hat oder nicht.

Der Schwellwertschalter enthält weiterhin einen schematisch dargestellten Differenzverstärker DIFF mit zwei Eingängen. Der eine Eingang ist mit dem Ausgang REF1 der ersten Referenzspannungsquelle UREF1 verbunden. Der andere Eingang ist mit dem Ausgang REF2 der zweiten Referenzspannungsquelle UREF2 verbunden. Am Ausgang des Differenzverstärkers DIFF liegt im Betrieb ein Freigabesignal $\phi$ an, das das Erreichen des Minimalwertes VCCmin des zweiten Versorgungspotentials VCC anzeigt.

Die erste Referenzspannungsquelle UREF1 ist in einer bevorzugten Ausführungsform eine Spannungsteilerschaltung, insbesondere von der Art, daß sie die an ihr anliegende Spannung ( = Differenz der Versorgungspotentiale VCC,VSS) halbiert. Es ist dabei günstig, sie als ohm'sche Spannungsteilerschaltung zu gestalten. Dabei ist es vorteilhaft, sie in Form implantierter Widerstände in einer integrierten Schaltung zu realisieren, beispielsweise mit einem spezifischen Widerstandswert von 1 kOhm je Flächeneinheit. Die erste Referenzspannungsquelle UREF1 ist dadurch weitgehend unabhängig von in verschiedenen Herstellungsprozessen auftretenden Toleranzen.

Es ist jedoch auch eine kapazitive Spannungsteilerschaltung möglich (Serienschaltung von Kapazitäten).

Die zweite Referenzspannungsquelle UREF2 enthält vorteilhafterweise eine Kettenschaltung von Dioden D und in Serie dazu einen Transistor T. Die Anzahl der Dioden D ist so zu bemessen, daß die Summe ihrer Diodenflußspannungen $V_{TD}$ kleiner ist als der Minimalwert VCCmin des zweiten Versorgungspotentials VCC. Es ist günstig, die Dioden D in Form von pn-Übergängen eines Halbleitermaterials zu realisieren, beispielsweise mittels n-dotiertem Silizium und p+-Implantation. Gegenüber einer Realisierung mittels als Dioden geschalteten Transistoren weist diese Ausführungsform eine große Unabhängigkeit von herstellungsprozeßbedingten Toleranzen auf (beispielsweise entfällt die Erzeugung von Gateoxiden, die zum Teil große Toleranzen aufweisen können von Herstellungsprozeß zu Herstellungsprozeß). Mit solcherart realisierten Dioden D lassen sich Toleranzwerte bei der Diodenflußspannung $V_{TD}$ von ± 30 mV erreichen (von Diode zu Diode und von erfindungsgemäßer Anordnung zu (einer anderen gleichen) erfindungsgemäßen Anordnung.

Weiterhin ist es günstig, den Differenzverstärker DIFF so auszulegen, daß sein Ausgangssignal $\phi$ einen ersten Wert V0 aufweist, solange der Ausgang REF1 der ersten Referenzspannungsquelle UREF1 ein kleineres Potential aufweist als der Ausgang REF2 der zweiten Referenzspannungsquelle UREF2 und daß es einen zweiten Wert V1 aufweist, wenn der Ausgang REF1 der ersten Referenzspannungsquelle UREF1 ein größeres Potential aufweist als der Ausgang REF2 der zweiten Referenzspannungsquelle UREF2. Der zweite Wert V1 kann dabei gleich dem aktuellen Wert des zweiten Versorgungspotentials VCC sein. Die erste Referenzspannungsquelle UREF1 bestimmt damit den Schaltpunkt des Differenzverstärkers DIFF. Sie ist demzufolge in Abhängigkeit vom gewünschten Minimalwert VCCmin zu dimensionieren.

Der Ausgang REF2 der zweiten Referenzspannungsquelle UREF2 zeigt im Betrieb folgendes zeitliche Verhalten (vgl. FIG 2):

Beim Anschalten des zweiten Versorgungspotentials VCC weist dieses noch den Wert des ersten Versorgungspotentials VSS auf. Dieser Wert ändert sich beispielsweise stetig in Richtung des angestrebten Endwertes. Der Ausgang REF2 nimmt bei diesem Anschaltvorgang ebenfalls die momentanen Werte des zweiten Versorgungspotentials VCC an und steigt mit dessen Ansteigen an bis zu einem Wert, der der Summe der Diodenflußspannungen $V_{TD}$ der Diodenkette D entspricht. Im Beispiel ist dieser Wert = $3V_{TD}$, da die Anordnung nach FIG 1 drei Dioden D (mit angenommenermaßen jeweils gleicher Diodenflußspannung $V_{TD}$) enthält. Der Zeitpunkt, zu dem dies geschieht, ist in FIG 2 mit t1 bezeichnet. Diesen Wert ($3V_{TD}$) behält der Ausgang REF2 bei einem weiteren Ansteigen des zweiten Versorgungspotentials VCC bei, weil nun der Transistor T, dessen Gate mit dem ersten Versorgungspotential VSS verbunden ist, zunehmend leitend wird und über ihn die (zeitlich zunehmende) Potentialdifferenz VCC - $3V_{TD}$ abfällt.

Beim weiteren Ansteigen des Wertes des zweiten Versorgungspotentials VCC erreicht dieses dann zum Zeitpunkt t2 den doppelten Wert der Summe der Diodenflußspannungen $V_{TD}$, d.h. im Beispiel den Wert $6V_{TD}$. Bei diesem Wert hat der Ausgang REF1 der ersten Referenzspannungsquelle UREF1 wegen der Spannungsteilerfunktion der ersten Referenzspannungsquelle UREF1 den Spannungswert $3V_{TD}$, was wiederum dem Spannungswert des Ausgangs REF2 der zweiten Referenzspannungsquelle UREF2 entspricht. Zum Zeitpunkt t2 gilt also: Spannungswerte der Ausgänge REF1,REF2 = $3V_{TD}$ und VCC = doppelte Summe der Diodenflußspannungen $V_{TD}$ (im Beispiel: $6V_{TD}$). Dies jedoch ist gleichzeitig gleich dem Wert VCCmin, den der Schwellwertschalter erkennen soll. Bis zum Zeitpunkt t2 war der Spannungswert des Ausgangs REF2 stets größer als der Spannungswert des Ausgangs REF1; das Freigabesignal φ des Ausgangs des Differenzverstärkers DIFF zeigte demzufolge den ersten Wert V0. Der erste Wert V0 kann beispielsweise gleich dem Wert des ersten Versorgungspotentials VSS sein.

Ab dem Zeitpunkt t2 ist, unabhängig davon, ob der Wert des zwei ten Versorgungspotentials VCC über den Minimalwert VCCmin hinaus ansteigt oder nicht, der Spannungswert des Ausgangs REF2 nicht mehr größer als der Spannungswert des Ausgangs REF1. Der Differenzverstärker DIFF erkennt dies und schaltet das Freigabesignal φ seines Ausgangs auf den zweiten Wert V1. Dieser kann dabei gleich dem aktuellen Wert des zweiten Versorgungspotentials VCC ab dem Zeitpunkt t2 sein.

Der erfindungsgemäße Schwellwertschalter weist bei den Dioden D, wie bereits erwähnt, Herstellungstoleranzen bezüglich deren Durchflußspannungen $V_{TD}$ von ca. ± 30 mV auf. Der Wert einer Durchflußspannung $V_{TD}$ einer Diode, die in Silizium realisiert ist, weist bekanntlich typischerweise 0,7 V auf. An der gezeigten Kettenschaltung von drei Dioden D der zweiten Referenzspannungsquelle UREF2 fällt also insgesamt eine Gesamtspannung von 3 . 0,7 V = 2,1 V in ab im Betrieb. Wegen der Spannungsteilerwirkung der ersten Referenzspannungsquelle UREF1 schaltet das Freigabesignal φ von seinem ersten Wert V0 auf seinen zweiten Wert V1, wenn das zweite Versorgungspotential VCC den doppelten Wert der obengenannten Gesamtspannung erreicht, im Beispiel also bei 2 . 2,1 V = 4,2 V. Die obengenannten Herstellungstoleranzen wirken sich analog aus: Die Kettenschaltung von Dioden D weist also eine Gesamttoleranz von ± 3 . 30mV = 90mV auf. Auf das Freigabesignal φ wirkt sich wiederum der doppelte Wert der Gesamttoleranz, d.h. also im Beispiel ein Wert von ± 180mV aus. Im vorliegenden Beispiel ergibt sich unter Berücksichtigung der auftretenden Fehlertoleranzen als Wert, bei dem der Schwellwertschalter anspricht ( = zu erkennender Minimalwert VCCmin), ein Wert von
VCCmin = 4,2 V ± 180 mV.

Der bezüglich der auftretenden Toleranzen als hervorragend zu bezeichnende Wert ist bei Anwendung innerhalb einer integrierten Halbleiterschaltung mit zusätzlicher Substratvorspannung (im allgemeinen mit dem Symbol "VBB" bezeichnet) zudem weitestgehend unabhängig vom Wert und von den Änderungen dieser Substratvorspannung.

Vorteilhafterweise ist die Spannungsteilerschaltung bezüglich ihrer Spannungsteilerfunktion so dimensioniert, daß im Betrieb an ihrem Ausgang REF1 ein elektrisches Potential anliegt, das, multipliziert mit der Summe der Diodenflußspannungen $V_{TD}$ der Dioden D der Diodenkette, gleich ist dem zu erkennenden Minimalwert VCCmin. Wird die Spannungsteilerschaltung beispielsweise so dimensioniert, daß das an ihrem Ausgang REF1 anliegende Potential gleich einem Drittel der Differenz der Versorgungspotentiale VSS,VCC ist, so wird durch den Differenzverstärker bei Verwendung von drei Dioden D in der Diodenkette ein Minimalwert VCCmin von $3(3V_{TD})$ = 6 .3 V detektiert. Dies kann nun dazu verwendet werden, zu erkennen, ob das zweite Versorgungspotential VCC den Minimalwert VCCmin überschreitet. Das heißt, in anderen Worten ausgedrückt, die erfindungsgemäße Anordnung ist bei geeigneter Dimensionierung auch geeignet, das Überschreiten eines vorgegebenen Wertes eines Potentials zu erkennen. Dies kann man beispielsweise dazu ausnützen, den integrierten Halbleiterschaltkreis intern abzuschalten, wenn seine Versorgungsspannung einen vorgegebenen Maximalwert überschreitet.

**Ansprüche**

1. Schwellwertschalter zum Erkennen eines Minimalwertes (VCCmin) eines elektrischen Potentials, enthaltend eine erste und eine zweite Referenzspannungsquelle (UREF1,UREF2), die beide einerseits mit einem ersten Versorgungspotential (VSS) und andererseits mit einem zweiten Versorgungspotential (VCC), dessen Minimalwert (VCCmin) erkannt werden soll, verbunden sind und mit einem Differenzverstärker (DIFF), dessen einer Eingang mit dem Ausgang (REF1) der ersten Referenzspannungsquelle (UREF1) verbunden ist und dessen anderer Eingang mit dem Ausgang (REF2) der zweiten Referenzspannungsquelle (UREF2) verbunden ist und an dessen Ausgang im Betrieb ein Freigabesignal ($\phi$) anliegt zur Anzeige des Erreichens des Minimalwertes (VCCmin).

2. Schwellwertschalter nach Anspruch 1, **dadurch gekennzeichnet,** daß die erste Referenzspannungsquelle (UREF1) eine Spannungsteilerschaltung ist.

3. Schwellwertschalter nach Anspruch 2, **dadurch gekennzeichnet,** daß die Spannungsteilerschaltung eine ohm'sche Spannungsteilerschaltung ist.

4. Schwellwertschalter nach Anspruch 3, **dadurch gekennzeichnet,** daß die ohm'sche Spannungsteilerschaltung durch Implantation in einem Halbleitermaterial realisiert ist.

5. Schwellwertschalter nach einem der vorhergehenden Ansprüche, **dadurch gekennzeichnet,** daß die zweite Referenzspannungsquelle (UREF2) eine Diodenkette (D) und einen Transistor (T) enthält.

6. Schwellwertschalter nach Anspruch 5, **dadurch gekennzeichnet,** daß die Diodenkette (D) durch Dioden realisiert ist, die die Diodenwirkung von pn-Übergängen eines Halbleitermaterials ausnutzen.

7. Schwellwertschalter nach einem der vorhergehenden Ansprüche, **dadurch gekennzeichnet,** daß das Freigabesignal ($\phi$) des Differenzverstärkers (DIFF) einen ersten Wert (V0) aufweist, solange der Ausgang (REF1) der ersten Referenzspannungsquelle (UREF1) ein kleineres elektrisches Potential aufweist als der Ausgang (REF2) der zweiten Referenzspannungsquelle (UREF2) und ansonsten einen zweiten Wert (V1).

8. Schwellwertschalter nach einem der Ansprüche 5 bis 7, **dadurch gekennzeichnet,** daß die Spannungsteilerschaltung bezüglich ihrer Spannungsteilerfunktion so dimensioniert ist, daß im Betrieb an ihrem Ausgang (REF1) ein elektrisches Potential anliegt, das, multipliziert mit der Summe der Diodenflußspannungen ($V_{TD}$) der Dioden (D) der Diodenkette, gleich ist dem zu erkennenden Minimalwert (VCCmin).

# FIG 1

VCC

VCC

UREF1 $\{$ 

REF1

DIFF

REF2

T~

VSS

$\}$ UREF2

D

D

D

$\Phi$

VSS

VSS

# FIG 2

U

VCC

$\Phi$

VCC min

REF1

$3V_{TD}$

REF2

VSS

t1

t2

t

Europäisches
Patentamt

**EUROPÄISCHER RECHERCHENBERICHT**

Nummer der Anmeldung

EP 89 10 8610

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | IBM TECHNICAL DISCLOSURE BULLETIN, vol. 28, no. 11, April 1986, pages 4815-4816, Armonk, New York, US; "Reset circuit for microprocessors" * Seite 4815, Zeile 7 - Seite 4816, Zeile 25; Figur * | 1,3,7 | H 03 K 17/30 H 03 K 17/22 |
| Y | IDEM | 4-6 | |
| Y | NEW ELECTRONICS, vol. 19, no. 4, February 1986, Seiten 54-56, London, GB; C. SUTTLIEFF: "Analogue and special cells for CMOS gate arrays" * Seite 55, Figur 3 mit Erläuterung * | 4 | |
| Y | EP-A-0 080 874 (FUJITSU LTD) * Seite 4, Zeilen 21-37; Figur 2 * | 5,6 | |

**RECHERCHIERTE SACHGEBIETE (Int. Cl.5)**

H 03 K
G 06 F

Der vorliegende Recherchenbericht wurde für alle Patentansprüche erstellt

| Recherchenort | Abschlußdatum der Recherche | Prüfer |
|---|---|---|
| DEN HAAG | 12-01-1990 | CANTARELLI R.J.H. |